(19) **Europäisches Patentamt**
**European Patent Office**
**Office européen des brevets**

(11) **EP 3 343 236 A1**

(12) **EUROPEAN PATENT APPLICATION**

(43) Date of publication:
**04.07.2018 Bulletin 2018/27**

(51) Int Cl.:
**G01R 21/133** (2006.01) **G01R 22/10** (2006.01)

(21) Application number: **16207560.0**

(22) Date of filing: **30.12.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Kamstrup A/S**
**8660 Skanderborg (DK)**

(72) Inventor: **Kirkegaard, Dennis**
**8850 Bjerringbro (DK)**

(74) Representative: **Plougmann Vingtoft a/s**
**Rued Langgaards Vej 8**
**2300 Copenhagen S (DK)**

(54) **ELECTRICITY METER WITH AN IMPEDANCE LEARNING ALGORITHM**

(57)  The present invention relates to an electricity meter for measuring electricity consumption in an electricity distribution network with three phases, in which the electricity meter comprises, a measuring circuit for measuring voltages and currents for each of the three phases, so to calculate the electric energy for each phase supplied from the electricity distribution network; an impedance learning algorithm unit arranged to estimate an impedance value of the electrical grid, wherein the impedance learning algorithm unit being arranged to, calculate zero sequence components and negative sequence components of the three phases, based on measured voltages and currents, from the zero sequence components, calculate a zero sequence voltage ($V_0$) and a zero sequence current ($I_0$), from the negative sequence components, calculate a negative sequence voltage ($V_2$) and a negative sequence current ($I_2$), estimate a zero sequence impedance ($Z_0$), based on a ratio between changes in the zero sequence voltage ($\Delta V_0$), and changes in the zero sequence current ($\Delta I_0$), estimate a negative sequence impedance ($Z_2$), based on a ratio between changes in the negative sequence voltage ($\Delta V_2$) and changes in the negative sequence current ($\Delta I_2$). The invention also relates a system of a plurality of electricity meters with an impedance learning algorithm unit, each arranged for measuring electricity data of a supplied utility and a data collector for collecting the electricity data, including impedance values, the electricity meters and the data collecto being arranged as data nodes in a communication network; wherein the electricity data, including impedance values, are being used to form a network model of the electricity distribution network of the plurality of electricity meters; wherein the network model of the electricity distribution network, provides information about the electricity distribution network; and wherein a distribution system operator operates the system according to the network model.

Figure 4

**Description**

FIELD OF THE INVENTION

The invention relates to an electricity meter, particularly an electricity meter for measuring electricity consumption in polyphasic electricity systems, including high-precision meters for measuring electricity consumption of a user in an electricity supply network in connection with payment to the electricity provider for consumed electric energy.

BACKGROUND OF THE INVENTION

In an electricity distribution network supplying energy to a number of consumers, the electric energy provider needs to be able to measure the electric energy consumed or provided by the individual consumers. Each consumer have an electricity meter installed, which measure the electric energy consumption at the connection point of the consumer.

The electrical network is normally divided in to two levels, a transmission network level and a distribution network level. The transmission network is operated at high voltages above 60kV and the distribution network is operated below 60kV. Most consumers are connected to the distribution network at voltage below 10kV, and again the majority are in fact connected at low voltages below 1000V.

In the transmission network, the grid, i.e. cables, transformers generators etc. is well defined with known impedances, allowing the Transmission System Operator (TSO) to simulate load flows based on known parameters. Whereas when looking at the distribution network often only the main components are known. This makes it more difficult to predict overload and system stability for the Distribution System Operator (DSO). When it comes to overload and faults, it is important to know the Short Circuit (SC) current, which may occur during a fault.

Today SC currents is determined by calculations with input from transformer-, radial- and service wire impedances. Alternative, the impedances is measured and SC current calculated with special equipment installed in near of the point of supply. In the first case the SC current is based on theoretical measures only and may differ from the true SC current in case of incorrect numbers. In the second case, expensive equipment and manual work are involved.

The electricity meters of the prior art, have the drawback that they do not provide the distribution system owner, DSO with informations about the electrical distribution network, other than drawn power, i.e. voltage and current based. It is an object of the present application to discloses electricity meters, which provide the DSO with information about the impedance the electricity meters sees in the electrical distribution network.

SUMMARY OF THE INVENTION

According to an aspect of the present invention there is provided an electricity meter for measuring electricity consumption in an electricity distribution network with three phases, in which the electricity meter comprises

- a measuring circuit for measuring voltages and currents for each of the three phases, so to calculate the electric energy for each phase supplied from the electricity distribution network;

- an impedance learning algorithm unit arranged to estimate an impedance value seen at the electricity meter, wherein the impedance learning algorithm unit being arranged to,

- calculate zero sequence components and negative sequence components of the three phases, based on measured voltages and currents,

- from the zero sequence components, calculate a zero sequence voltage and a zero sequence current,

- from the negative sequence components, calculate a negative sequence voltage and a negative sequence current,

- estimate a zero sequence impedance, based on a ratio between changes in the zero sequence voltage, and changes in the zero sequence current,

- estimate a negative sequence impedance, based on a ratio between changes in the negative sequence voltage and changes in the negative sequence current.

An advantage of the first aspect is that the electricity meter provides the impedance seen at the electricity meter, based on values already measured at the meter. The electricity meters are installed in the distributions grid, therefore information about impedances in the distributions grid are obtained.

In one embodiment the impedance learning algorithm unit further being arranged to estimate the negative sequence impedance and estimate the zero sequence impedance by using Least Square algorithms, especially minimum Least Square algorithms.

An advantage of this embodiment is that the impedance is estimated by the ratio of two summations.

The embodiments of the invention can also be considered to encompass, the impedance learning algorithm unit further being arranged to,

- approximate by an auto-regressive (AR) process the zero sequence impedance, wherein the auto-regressive (AR) process comprises a first forgetting factor, and

- approximate by an auto-regressive (AR) process the negative sequence impedance, wherein the auto-regressive (AR) processes comprises a second forgetting factor.

An advantage of this embodiment is that is minimizes the use of data memory.

In one embodiment, the first forgetting factor and second forgetting factor are dynamical factors depending on the ratio of the changes in the sequence current to a summarized current change.

An advantage of this embodiment is that the system is less sensitive to voltage noise from the grid.

In one embodiment, the summarized current change is limit by a maximum measured current value of the electricity meter.

An advantage of this embodiment is that the small current changes has less weight than larger current changes.

In one embodiment, the electricity meter further comprising a low pass filter, arranged to filter out higher harmonics of the measured voltages and currents. An advantage of this embodiment is that higher harmonics are filtered out, and higher harmonics of negative sequence or positive sequence will have less effect on the impedance.

In one embodiment, the electricity meter further comprising a unit to receive a GPS time signal.

In one embodiment, the voltage changes and current changes of the measurements are measured over a time interval of 5 to 30 seconds.

In one embodiment, the electricity meter comprises a communication module arranged to transmit the impedance value to a data collector.

An advantage of this embodiment is that the electricity meters are installed in the distributions grid, therefore information about impedances in the distributions grid are collected and can be used in a model of the distributions grid.

According to a second aspect of the present invention there is provided a method to estimate grid impedance in a distribution network with three phases, wherein the method comprises:

- measuring voltages and currents for each of the three phases, so to calculate the electric energy for each phase supplied from the electricity distribution network;

- estimating an impedance value of the electrical grid by an impedance learning algorithm, wherein the impedance learning algorithm comprises,

- calculating zero sequence components and negative sequence components of the three phases, based on measured voltages and currents;

- calculating from the zero sequence components, a zero sequence voltage and a zero sequence current;

- calculating from the negative sequence components, a negative sequence voltage and a negative sequence current;

- estimating a zero sequence impedance, based on a ratio between changes in the zero sequence voltage, and changes in the zero sequence current;

- estimating a negative sequence impedance, based on a ratio between changes in the negative sequence voltage and changes in the negative sequence current.

According to a third aspect of the present invention there is provided a system of a plurality of electricity meters according to the embodiment of the electricity meter, each arranged for measuring electricity data of a supplied utility and a data collector for collecting the electricity data, including impedance values, the electricity meters and the data collector being arranged as data nodes in a communication network;

- wherein the electricity data, including impedance values, are being used to form a network model of the electricity distribution network of the plurality of electricity meters;

- wherein the network model of the electricity distribution network, provides information about the electricity distribution network; and

- wherein a distribution system operator operates the system according to the network model.

It is appreciated that any sub aspect mentioned in connection with the first aspect may in any way be combined with any of the sub aspects of the second and third aspect.

BRIEF DESCRIPTION OF DRAWINGS

In the following, the invention will be described in more details by referring to embodiments illustrated in the accompanying drawings, of which:

Figure 1 shows a block diagram of an electricity meter;

Figure 2 shows details of a measurement circuit of a electricity meter;

Figure 3 shows a classical system representations of a single installation along a distribution line;

Figure 4 shows a symmetrical system equivalent;

Figure 5 illustrates a system comprising a plurality of consumption meters and a data collector.

DETAILED DESCRIPTION

In case of having a Impedance Learning Algorithm (ILA) included in the electricity meter, the SC current level can continuously be estimated. This allows Distribution System Operators (DSOs) to monitor the condition of the low voltage (LV) distribution grid, without installation of extra and expensive equipment. By this, action can be taken by the DSO if the impedances estimated by ILA, do not comply with the theoretical or former estimated impedances. In some cases, this could be a symptom of bad connections, which could cause melt down or - in case of broken neutral wire - overvoltage with extensive damages to follow.

The purpose of the Impedance Learning Algorithm (ILA) is to estimate the impedance in front of the electricity meter, i.e. the impedance from the substation to the terminals of the meter. The impedance may be used to determine the short circuit current at the end user's point of consumption, i.e. where the meter is measurering electrical parameters.

Electrical impedance is the measure of the complex ratio of the voltage to the current in an alternating current (AC) circuit. The impedance therefore has two orthogonal vectors, where resistance forms the real part of complex impedance, and reactance forms the imaginary part of complex impedance.

The electrical grid comprises a plurality of consumers, distribution lines and generators or sources, all of which changes over time. The impedance seen from each electricity meter therefore changes every time the configuration of the grid changes, a change in the configuration can be very small when a small load and its sub system is connected, or larger when a large load and its sub system is connected. In the simple system impedance is the resistance and reactance from the meter to the source / generator, and the impedance measured at the electricity meter is the impedance seen by the meter from the terminals to the power source. In reality the impedance is the resistance and reactance the meter sees into the electrical grid, as it is not only source and a simple power line, every single component in the electrical grid contributes to the impedance, thus we talk about impedance value of the electrical grid which is seen by the electricity meter.

In respect of short circuit (SC) current, two measures are of primary interest. These are the maximum SC current (SC_MAX) and the minimum SC current (SC_MIN). SC_MAX determines the required grade of switching equipment at the point of supply and SC_MIN is used to calculate the energy deposing in cables in case of critical failure of SC between a live line and the neutral conductor. Wrong sizing according to the former, may cause explosion or fire in protection equipment during SC. Wrong sizing according to the latter, may cause cables to melt down before the fuses blows, in case of a SC, i.e. the protection level in the grid is not proper dimensioned.

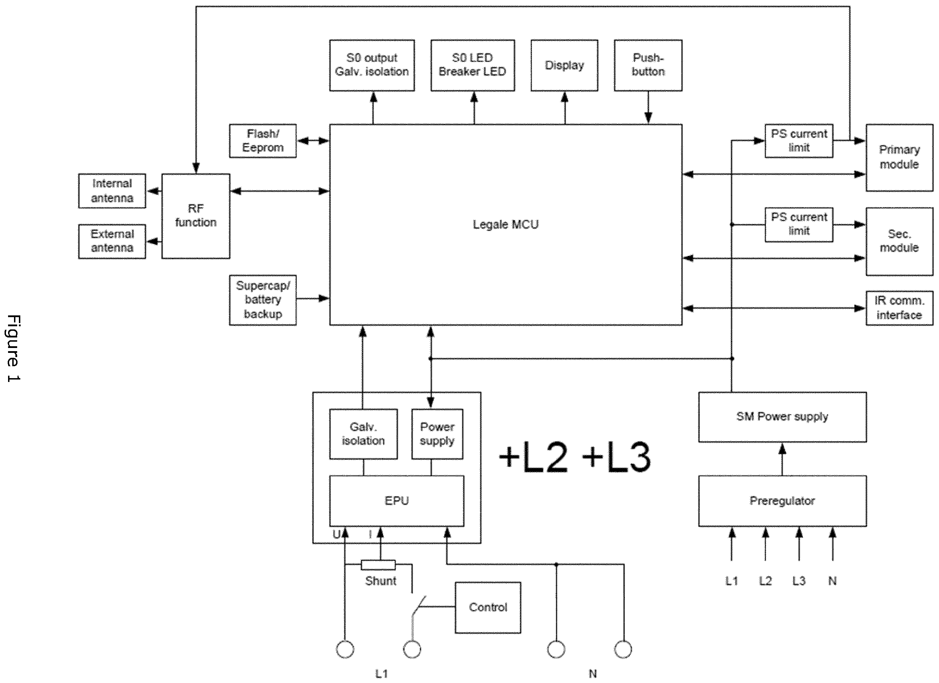

Figure 1 shows a block diagram of an electricity meter with its main elements. The heart of the electricity meter is the Legal MCU, which handles the data processing of the measured values in order to sum the comsumed power. The impedance learning algorithm ILA is also included in the Legal MCU, the ILA will be further described in the following pages. The the electricity meter measures voltages U and currents I for each of the three electrical phases L1, L2, L3, for measuring the total electricity consumption on the three phases. N denotes "neutral". Only phase L1 is shown in details, but phases L2 and L3 comprise the same features. The current signal is measured through a shunt resistor and send to the EPU block, current measurement can be opened or closed by a switch by the control block, and thereby allowing current to flow in the shunt. After the EPU block the signals are galvanic isolated prior to be sent to the MCU block, the EPU is fed by a power supply circuit.

This present invention is not limited to embodiments where the current is measured using a shunt resistor, it should include other types of measurement circuits, such as current measurement circuits based on current transformers and/or Hall effect circuits.

The power supply is handled by the switch mode (SM) power supply, which in fact is supplied by the electrical phases, the preregulator mainly consist of a rectifier circuit. Left of the MCU block there are RF function block and two antenna block which handles the communication of the measurements such as the impedans value. The RF function block is the communication module and coupled to the calculating circuit, in such a way that the measurements, and any other data, may be sent wirelessly in a wireless network, or directly to a data collector.

In addition there several other functions shown in Figure 1, which are relevant for the meter, but not for the understanding of the present invention.

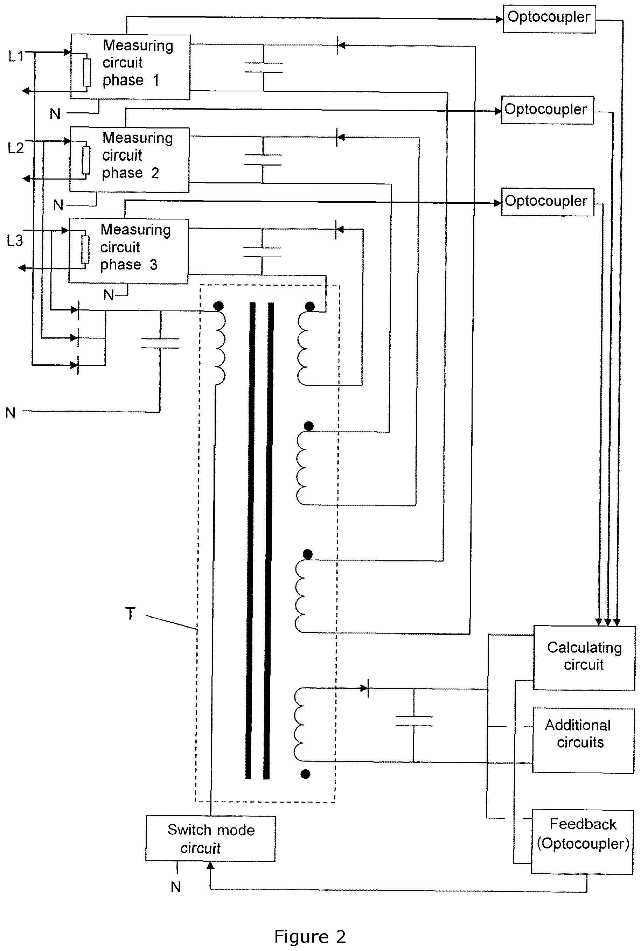

Figure 2 shows details of an electricity meter. Separate measuring circuits for each of the phases LI, L2, L3 measure and calculate an energy consumption for each phase and communicate this result, via an optocoupler, to a calculation circuit which sums up the consumption results for each of the phases LI, L2, L3 and thus calculates a total energy consumption.

The separate measuring circuits for each of the three phases LI, L2, L3 are directly coupled to the phases LI, L2, L3 in such a way that they are able to measure the voltage of each of the phases LI, L2, L3. As indicated on figure 1, the measuring circuits determine the current drawn on each of the phases based on the shunt resistor principle. They are therefore coupled directly to the voltage potential for each phase and must therefore be supplied with voltage separately with galvanic separation. As can be seen in figure 1, the transformer T therefore has separate secondary windings which are galvanically separated from each other for voltage supply of each of the measuring circuits.

Calculating circuits, additional circuits and feedback (optocoupler) for the switch mode circuit in the switch mode voltage supply, are furthermore supplied with voltage from an additional secondary winding on the transformer T, as this secondary winding is galvanically separated from the secondary windings for the supply to the measuring circuits.

The primary winding of the transformer T is charged with energy from a coupled switch mode circuit operating with a switch frequency of preferably 100 kHz or more. As may be seen, the switch mode circuit is connected to the primary winding of the transformer, and the primary winding is connected to the phases LI, L2, L3 via diodes in such a way that there will be supply voltage to switch mode circuits and calculating circuits when there is just voltage on one of the three phases LI, L2, L3.

The electrical voltages and currents measured at the electricity meter contains all the harmonics present in the network, only limited by the bandwidth of the measurement system. Measuring electrical power, higher harmonics should be included, as they are also obtained by the consumer. On the other hand, higher harmonics such as 5th, 7th 11th and 13th may be seen as disturbances when using the voltages and currents to obtain other values, such as impedances. Low pass filtering of the signals may therefore be advantageous. The filtering can be done with analogue filters prior to measurement, if only one set of measurements are used, as in Figure 1, the power measurement lacks the contribution from the higher harmonics. Digital filtering is therefore preferred.

In an embodiment the voltage and current signals are digitally low pass filtered prior to be used for impedance estimation.

The impedances in a distribution grid can be described in symmetrical components known as the positive sequence impedance ($Z_1$), the negative sequence impedance ($Z_2$) and the zero sequence impedance ($Z_0$), which is known to the skilled person. By the nature of symmetrical components, the positive-, negative-and zero sequences does not affect each other's and could be estimated independently. At the same time, the positive and negative sequence impedances in transformers and distribution systems are mainly equals. By this, we could estimate the positive sequence impedance by the negative sequence, as the negative sequence component is easier to estimate than the positive sequence component.

Refering back to the higher harmonics, some of them belongs to negative sequence components, some to positive sequence components and some to the zero sequence components. Harmonics such as the 5th and 11th, which "rotate" in the opposite sequence as the fundamental, are negative sequence components. Harmonics such as the 7th and 13th, which "rotate" with the same sequence as the fundamental, are positive sequence components. Triplen harmonics (3[r] and 9th) which don't "rotate" as they are in phase with each other, are zero sequence components, in a symmetrical 3 phase system triplen harmonics are not present, but for this application, where the loads in the households or like often are single phase and often non-linear, the triplen will be present, examples non-liniar single phase components can be low energy flourence lights.

This pattern of positive-zero-negative-positive continues indefinitely for all odd-numbered harmonics, but the higher the number of harmonic, the lower the content are present in the electrical grid. Harmonics comes from non-linear loads in the grid. $5^{th}$, $7^{th}$, $11^{th}$ and $13^{th}$ often come from electrical machines, both generators and motors.

The content of each of the harmonics differ and the level of $5^{th}$ harmonic is rarely the same as the level of $7^{th}$ harmonic. This means that the $5^{th}$ harmonics is added to the negative sequence components and the $7^{th}$ harmonics will be added to the positive sequence components. In elelctrical grids with high level of harmonic content and especially with a large difference between harmonics of positive sequence and harmonics of negative, the assumption that the negative and positive sequences are equal may become false. In such networks low pass filtering of the signals may benefit the accuracy of the impedance estimate.

In the following the symmetrical component is explained further, the zero sequence components will be noted by the subfix-0 (zero), the positive sequence components will be noted by the subfix-1 (one) and the negative sequence by the subfix-2. The traditional phase components will be denoted by subfix-a, -b and -c.

In the transform between normal and symmetrical components the complex size operator $\alpha$, denotes the 120 degree phase shift:

$$a = e^{i\frac{2\pi}{3}} = \cos(120°) + i\sin(120°)$$

The transformation matrix

$$T = \begin{bmatrix} 1 & 1 & 1 \\ 1 & a^2 & a \\ 1 & a & a^2 \end{bmatrix}$$

$$T^{-1} = \frac{1}{3}\begin{bmatrix} 1 & 1 & 1 \\ 1 & a & a^2 \\ 1 & a^2 & a \end{bmatrix}$$

determines the relationship between normal and symmetrical components as

$$V_{abc} = TV_{012}$$

and

$$V_{012} = T^{-1}V_{abc}$$

The symmetrical currents is calculated similar to the voltages, and the transformation of impedances into symmetrical components is

$$Z_{012} = T^{-1}Z_{abc}T$$

For transmission lines with balanced impedances, the special case appears that the symmetrical impedance matrix is diagonal

$$Z_{012} = \begin{bmatrix} Z_0 & 0 & 0 \\ 0 & Z_1 & 0 \\ 0 & 0 & Z_2 \end{bmatrix}$$

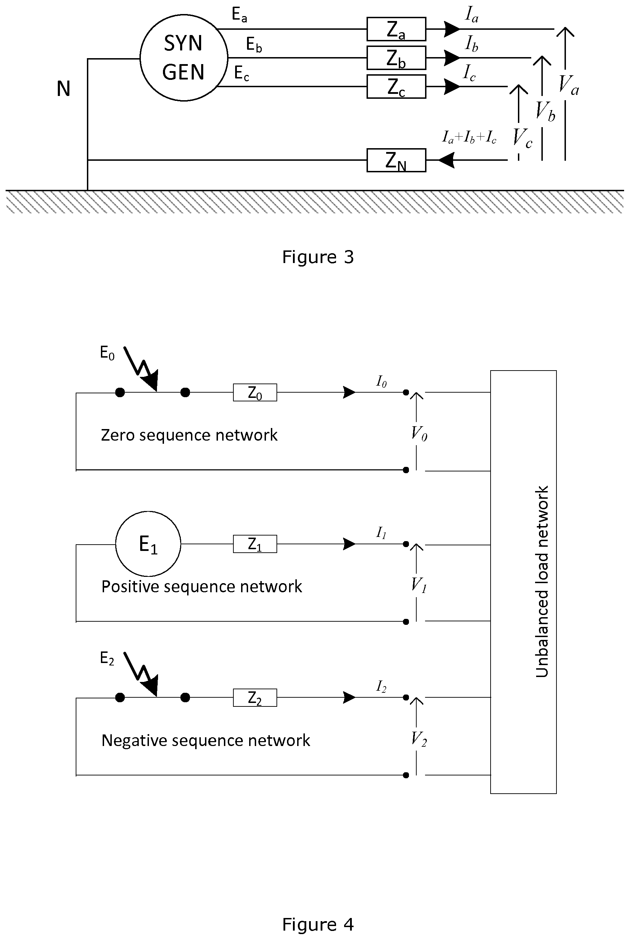

Figure 3 shows a classical system representations of a single grid installation with a generator along a distribution line, it includes a power generation unit SYN GEN with three phase output, $E_a$, $E_b$ and $E_c$, the power generation is in the form of a synchronous generator (alternatively it could be a Delta-wye coupled transformer), a set of balanced line impedances $Z_a$, $Z_b$ and $Z_c$, and some measures of unbalanced current $I_a$, $I_b$ and $I_c$, and voltages $V_a$, $V_b$ and $V_c$, to the installation at the end of the distribution line. This is the impedances $Z$ an electricity meter sees in a simple electrical grid.

Figure 4 shows a symmetrical system equivalent of Figure 3. Here, the generator of Figure 3 is changed to a symmetrical positive sequence generator $E_1$, which drives the positive sequence current $I_1$ through the positive sequence line impedance $Z_1$ and into an unbalanced load network (the end user's installation) which may distribute the current through the negative- or zero sequence impedances depending of the load configuration. Especially in case of unbalanced loading.

The components $I_0$, $I_1$ and $I_2$, and $V_0$, $V_1$ and $V_2$ may all be calculated by the unbalanced measures $V_a$, $V_b$, $V_c$, $I_a$, $I_b$ and $I_c$ inside the meter by

$$V_{012} = T^{-1}V_{abc}$$

and

$$I_{012} = T^{-1}I_{abc}$$

However, in the real world the precise figures of $E_1$ will be unknown. Further, the degree of balance is not guaranteed but is assumed static in a short time frame. The unbalanced nature of the power generator and grid-induced disturbances are shown with the sparks, $E_0$ and $E_2$ in the zero- and negative sequence networks respectively.

Each of the symmetrical networks could be identified individual. For this, we use the equation for voltage drop over the symmetrical impedance

$$E_2 - V_2 = I_2 Z_2$$

Here it is shown for the negative sequence. Similar equations could be made for the positive- and the zero sequence networks. To identify the symmetrical impedance we will focus on the change in load current to see what change in voltage measurement it causes. For this, we define a period at where E is assumed to be mainly static (5-10s). The value changes within this period is denoted by capital Delta, $\Delta$. By rearranging, we get for the negative sequence

$$Z_2 - \frac{\Delta E_2}{\Delta I_2} = -\frac{\Delta V_2}{\Delta I_2}$$

at which the injected voltage $E_2$ is mainly static and disappears as we focus on the changes

$$Z_2 \approx -\frac{\Delta V_2}{\Delta I_2}$$

A similar simplification could be made for the zero sequence network. However, the positive sequence network includes the generator and may need a very short period to be assumed static. By this, we concentrate on the zero sequence and the negative sequence network. But as the positive and negative sequence network have equal impedances, $Z_1$ will be estimated from $Z_2$. Summarized we have:

$$Z_1 = Z_2 \approx -\frac{\Delta V_2}{\Delta I_2}$$

$$Z_0 \approx -\frac{\Delta V_0}{\Delta I_0}$$

To identify $Z_0$ and $Z_2$ we use Minimum Least Square (MLS) techniques applied on series of delta values, i.e. voltage changes and current changes. These series might not be continuous time series but must be composed based on change in the load network. By this, we must prevent "dividing-by-zero" problems from arising.

For each time interval defining the $\Delta$, e.g. 10 seconds, we converts the measured voltage and current into to symmetrical components; zero- and negative sequence components:

$$\begin{bmatrix} V_0 \\ V_2 \end{bmatrix} = \frac{1}{3} \begin{bmatrix} 1 & 1 & 1 \\ 1 & a^2 & a \end{bmatrix} \begin{bmatrix} V_a \\ V_b \\ V_c \end{bmatrix} = \boldsymbol{V}_{\boldsymbol{02}}$$

$$\begin{bmatrix} I_0 \\ I_2 \end{bmatrix} = \frac{1}{3} \begin{bmatrix} 1 & 1 & 1 \\ 1 & a^2 & a \end{bmatrix} \begin{bmatrix} I_a \\ I_b \\ I_c \end{bmatrix} = \boldsymbol{I}_{\boldsymbol{02}}$$

Further, we calculate the load admittance for each phase:

$$\begin{bmatrix} Y_a \\ Y_b \\ Y_c \end{bmatrix} = \begin{bmatrix} I_a/V_a \\ I_b/V_b \\ I_c/V_c \end{bmatrix} = \boldsymbol{Y}_{\boldsymbol{abc}}$$

Based on the level of changed load admittances

$$\Delta \boldsymbol{Y}_{\boldsymbol{abc}}(n) = \boldsymbol{Y}_{\boldsymbol{abc}}(n) - \boldsymbol{Y}_{\boldsymbol{abc}}(n-1),$$

the algorithm proceeds. The level of change could be based on a simple threshold analysis of the phase admittances changes. Otherwise, the load admittances may be converted into symmetrical components and the decision to proceed may then depend on the change of current "injection" from the positive sequence system into the zero sequence- and negative sequence systems.

In case, the load admittances have changed a certain level, e.g. 4.348mS equivalent to approx. 1A at 230V, we proceed by calculating the deltas of the symmetrical voltage and current components:

$$\Delta \boldsymbol{V}_{\boldsymbol{02}}(n) = \boldsymbol{V}_{\boldsymbol{02}}(n) - \boldsymbol{V}_{\boldsymbol{02}}(n-1)$$

$$\Delta \boldsymbol{I}_{\boldsymbol{02}}(n) = \boldsymbol{I}_{\boldsymbol{02}}(n) - \boldsymbol{I}_{\boldsymbol{02}}(n-1)$$

The correlation between time series of these deltas is determined by the symmetrical impedance matrix without the positive sequence component

$$Z_{02} = \begin{bmatrix} Z_0 & 0 \\ 0 & Z_2 \end{bmatrix}$$

$$-\Delta \overline{\boldsymbol{V}}_{\boldsymbol{02}} = Z_{02} \Delta \overline{\boldsymbol{I}}_{\boldsymbol{02}}$$

and because $Z_{02}$ is assumed diagonal, we can treat it as two independent systems with independent correlations:

$$-\Delta \bar{V}_0 = Z_0 \Delta \bar{I}_0$$

$$-\Delta \bar{V}_2 = Z_2 \Delta \bar{I}_2$$

To solve the two systems in least squares sense we do the following matrix manipulation, omitting the deltas, numbers and bars to simplify:

$$Z = -VI^H (II^H)^{-1}$$

By the dimensionality of one for each sample, we can rewrite each system to

$$Z = -\frac{\sum VI^*}{\sum |I|^2}$$

The above equation gives us that the impedance can be found by the ratio between the two summations.
The number of samples we may summarize could be infinite, giving us an all-time best estimate of the impedance. However, to prevent numerical saturation and as the impedance may change slowly over time, as it will, due to reconfigurations of the grid, we could limit the summation to a certain interval defined by $\alpha$:

$$Z(n) = -\frac{\sum_{i=n-\alpha}^{n} V(i)I^*(i)}{\sum_{i=n-\alpha}^{n} |I(i)|^2}$$

This could be rewritten to two moving average FIR-filters of degree $\alpha$:

$$Z(n) = -\frac{\frac{1}{\alpha+1} \sum_{i=n-\alpha}^{n} V(i)I^*(i)}{\frac{1}{\alpha+1} \sum_{i=n-\alpha}^{n} |I(i)|^2}$$

To save memory in case of a large interval, one could consider to approximate the moving average MA($\alpha$) processes by an auto-regressive (AR) processes with the forgetting factor, $\rho$:

$$Z_{num}(n) = (1-\rho)Z_{num}(n-1) + \rho V(n)I^*(n)$$

$$Z_{den}(n) = (1-\rho)Z_{den}(n-1) + \rho |I(n)|^2$$

$$Z(n) = \frac{Z_{num}(n)}{Z_{den}(n)},$$

still remember that all voltage and currents are delta values.
The forgetting factor $\rho$ is a static number determines the weight of new sample-sets compared to the accumulated result. This is inappropriate, as it gives small delta currents, the same weight as the larger ones, making the system more sensitive to voltage noise from the grid. To improve the performance of ILA the forgetting factor is made dynamical by the ratio of the present current change to the summarized current change up to a certain limit of current:

$$\rho(n) = \frac{|\Delta I(n)|}{\min(\sum_n |\Delta I(n)| ; A)}$$

Where capital ALPHA, A, is an upper limit for summarizing current change stored in the memory of the electricity meter, e.g. 15kA (15,000 ampere). Finally the overall update algorithm is defined as

$$Z_{num}(n) = \left(1 - \rho(n)\right) Z_{num}(n-1) + \rho(n)\Delta V(n)\Delta I^*(n)$$

$$Z_{den}(n) = \left(1 - \rho(n)\right) Z_{den}(n-1) + \rho(n)|\Delta I(n)|^2,$$

which is done for both the zero sequence impedance $Z_0$ and the negative sequence impedance $Z_2$. The zero sequence impedance $Z_0$ and the negative sequence impedance $Z_2$ is thus calculated by the ratio between $Z_{num}$ and $Z_{den}$.

In a distribution network, as described earlier, it is important to know about impedances of the network in order to modulate the network for simulation purposes. Having a good and firm model of the distribution network will allow the DSO to detect faults and contingency risks before they cause problems.

The impedance values estimated by the electricity meters are of less value of its own, e.g. the single impedance value of the single electricity meter. Whereas the use of the collected impedance values from the entire population of electricity meter provides the DSO with information needed to make a better model of the distribution network, thus it is important to be able to collect the impedance value from the individual electricity meter, where each electricity meter becomes a node in the model. The collection is enabled by data communication between the electricity meter and a data collector.

In an embodiment the electricity meters estimates the impedance value seen at the measurement terminals of the meter (L1, L2, L3, and N) and transmit the impedance value to a data collector.

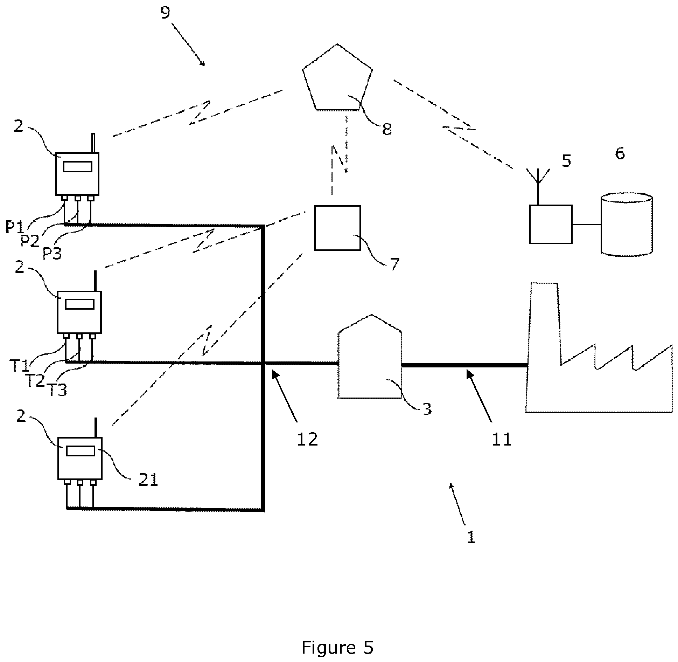

Figure 5 shows in connection with a radio network how a plurality of meters communicates the impedans values obtained at the meter location. The invention is relevant for all types of meter networks arranged in a complex topology, the invention is particularly relevant for networks which support complex topologies. Figure 5 illustrates a system 1 comprising a plurality of consumption meters 2 and a data collector 7, 8, here in the form of a sub-collector 7 and a main collector 8. Where each meter 2 measures electrical parameters at the three phases P1, P2, P3, and by data processing in the processor 21, meter data such as impedance, power consumption etc. is derived. The electrical power measured at the meters 2 is supplied from a power plant 10, and send via a transmission network 11 to a substation 3, which sends the power through a distribution network 12. Each meter 2 communicates 9 the electrical parameters and the meter data. The main collector being the collection system of the utility provider 10, whereas the sub-collector being a concentrator unit 7 arranged as a concentrator node in the network to collect the electrical parameters and the meter data from a group of consumption meters. The total network is advantageously a radio network, however at least the network between the concentrator and the consumption meters is a radio network, whereas the link between the two collector parts may be of any suitable type. The number of consumption meters in the plurality of meters may range from a few hundreds of meters to several thousands of meters connected in the network.

To ensure a network where all nodes (i.e. the consumption meters and other network devices) are connected in a way so there is a communication path 9 between each consumption meter and the main collector, a rather complex network often results, in particular in residential areas. For example meter 2 is connected to the main collector 8 via direct connection to the concentrator 7, such a meter may be referred to as a zero level meter. In a real large scale network, a large number of high level consumption meters may be found. The network may also be referred to as a multi-hop network. However, generally the network is a hybridized network based on a number of basic topologies, including but not limited to point-to-point, star, tree and mesh as the important topology types.

The data, from the meters 2 is communicated from the main collector 8 to a backend systemnd stored in an associated server 6. Based on the impedance values the DSO can make a model of its distribution grid.

Having a good network model, also allows the DSO to detect unexpected behaviour, such as tampering with the electricity meter, i.e. consuming power net detected by the meter.

In an embodiment, the system of a plurality of electricity meters provides impedance information to establish a network model.

The network model can be used to simulate the distribution network, and thereby provide information about SC levels and load flow issues. It can also be used to detect irregularities in the electrical power fed into the distribution network compared to the consumed power measured by the plurality of electricity meters, where the detection provides more precise information about the specific location of the potential meter tampering.

Although the estimate of the single impedance value is of less importance it can also be used to detect local grid issues such as cable degradation which often leads to cable faults.

Advanced electricity meters can be equipped with a unit to receive GPS based time signals, which is known to be extremely precise. Having a large number of the nodes in the model, each with an impedance value and a time stamp from the GPS signal, will furthermore allow the DSO to include phase values in the model and thereby get an even better model of the network. Such meters with a unit to receive GPS based time signals are very expensive and a good compromise is a meter which can estimate the impedance value without the GPS time signal.

In an embodiment each of the electricity meter comprises a unit to receive GPS based time signals.

In an embodiment, the system of a plurality of electricity meters comprises a first type of electricity meters without a unit to receive GPS based time signals and a second type of electricity meters with a unit to receive GPS based time signals. Wherein the second type of meters are installed at key nodes in the network, where it is important to receive more precise phase values. Whereas the remaining nodes provides the estimated impedance values.

**Claims**

1. An electricity meter for measuring electricity consumption in an electricity distribution network with three phases, in which the electricity meter comprises

   - a measuring circuit for measuring voltages and currents for each of the three phases, so to calculate the electric energy for each phase supplied from the electricity distribution network;
   - an impedance learning algorithm unit arranged to estimate an impedance value seen at the electricity meter, wherein the impedance learning algorithm unit being arranged to,

      - calculate zero sequence components and negative sequence components of the three phases, based on measured voltages and currents,
      - from the zero sequence components, calculate a zero sequence voltage ($V_0$o) and a zero sequence current ($I_0$),
      - from the negative sequence components, calculate a negative sequence voltage ($V_2$) and a negative sequence current ($I_2$),
      - estimate a zero sequence impedance ($Z_0$), based on a ratio between changes in the zero sequence voltage ($\Delta V_0$), and changes in the zero sequence current ($\Delta I_0$),
      - estimate a negative sequence impedance ($Z_2$), based on a ratio between changes in the negative sequence voltage ($\Delta V_2$) and changes in the negative sequence current ($\Delta I_2$).

2. The electricity meter according to claim 1, wherein the impedance learning algorithm unit further being arranged to,

   - estimate the negative sequence impedance ($Z_2$) and estimate the zero sequence impedance ($Z_0$) by using Least Square algorithms, especially minimum Least Square algorithms.

3. The electricity meter according to claims 1 or 2, wherein the impedance learning algorithm unit further being arranged to,

   - approximate by an auto-regressive (AR) process the zero sequence impedance ($Z_0$), wherein the auto-regressive (AR) process comprises a first forgetting factor (po), and
   - approximate by an auto-regressive (AR) process the negative sequence impedance ($Z_2$), wherein the auto-regressive (AR) processes comprises a second forgetting factor ($\rho_2$).

4. The electricity meter according to claim 3, wherein the first forgetting factor (po), and second forgetting factor ($\rho_2$) are dynamical factors depending on the ratio of the changes in the sequence current ($\Delta I_0$, $\Delta I_2$) to a summarized current change.

5. The electricity meter according to claim 4, wherein the summarized current change is limit by a maximum measured current value of the electricity meter.

6. The electricity meter according to any of claims 1 to 5, further comprising a low pass filter, arranged to filter out higher harmonics of the measured voltages and currents.

7. The electricity meter according to any of claims 1 to 6, further comprising a unit to receive a GPS time signal.

8. The electricity meter according to any of claims 1 to 7, wherein the voltage changes and current changes of the measurements are measured over a time interval of 5 to 30 seconds.

9. The electricity meter according to any of claims 1 to 8, wherein the electricity meter comprises a communication module arranged to transmit the impedance value to a data collector.

10. Method to estimate grid impedance in a distribution network with three phases, wherein the method comprises:

- measuring voltages and currents for each of the three phases, so to calculate the electric energy for each phase supplied from the electricity distribution network;
- estimating an impedance value of the electrical grid by an impedance learning algorithm, wherein the impedance learning algorithm comprises,
- calculating zero sequence components and negative sequence components of the three phases, based on measured voltages and currents;
- calculating from the zero sequence components, a zero sequence voltage ($V_0$) and a zero sequence current ($I_0$);
- calculating from the negative sequence components, a negative sequence voltage ($V_2$) and a negative sequence current ($I_2$);
- estimating a zero sequence impedance ($Z_0$), based on a ratio between changes in the zero sequence voltage ($\Delta V_0$), and changes in the zero sequence current ($\Delta I_0$);
- estimating a negative sequence impedance ($Z_2$), based on a ratio between changes in the negative sequence voltage ($\Delta V_2$) and changes in the negative sequence current ($\Delta I_2$).

11. A system of a plurality of electricity meters according to claims 1 to 6, each arranged for measuring electricity data of a supplied utility and a data collector for collecting the electricity data, including impedance values, the electricity meters and the data collector being arranged as data nodes in a communication network;

- wherein the electricity data, including impedance values, are being used to form a network model of the electricity distribution network of the plurality of electricity meters;
- wherein the network model of the electricity distribution network, provides information about the electricity distribution network; and
- wherein a distribution system operator operates the system according to the network model.

Figure 1

Figure 2

Figure 3

Figure 4

Figure 5

Europäisches
Patentamt

European
Patent Office

Office européen
des brevets

# EUROPEAN SEARCH REPORT

**Application Number**

EP 16 20 7560

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2008/204054 A1 (WELLS CHARLES H [US]) 28 August 2008 (2008-08-28) * paragraphs [0015] - [0035]; figures 1-4 * | 1-11 | INV. G01R21/133 G01R22/10 |
| Y | WEN FAN ET AL: "Intelligent data analysis for power systems", 2012 IEEE POWER AND ENERGY SOCIETY GENERAL MEETING ; SAN DIEGO, CALIFORNIA, USA; 22 - 26 JULY 2012, IEEE, PISCATAWAY, NJ, 22 July 2012 (2012-07-22), pages 1-8, XP032465590, DOI: 10.1109/PESGM.2012.6344953 ISBN: 978-1-4673-2727-5 * page 6, left column, third paragraph from the bottom * | 1-11 | |
| A | US 2012/191440 A1 (MEAGHER KEVIN [US] ET AL) 26 July 2012 (2012-07-26) * paragraphs [0066], [0265]; figures 1-10 * | 1-11 | |
| Y | US 2014/320148 A1 (SHARMA SANTOSH KUMAR [IN] ET AL) 30 October 2014 (2014-10-30) * paragraphs [0021], [0022], [0023], [0024], [0025]; figures 1-5 * | 1,10 | TECHNICAL FIELDS SEARCHED (IPC) G01R |
| A | | 2-9,11 | |

The present search report has been drawn up for all claims

| Place of search | Date of completion of the search | Examiner |
|---|---|---|
| Munich | 9 June 2017 | O'Callaghan, D |

EPO FORM 1503 03.82 (P04C01)

EP 3 343 236 A1

**ANNEX TO THE EUROPEAN SEARCH REPORT
ON EUROPEAN PATENT APPLICATION NO.**

EP 16 20 7560

This annex lists the patent family members relating to the patent documents cited in the above-mentioned European search report.
The members are as contained in the European Patent Office EDP file on
The European Patent Office is in no way liable for these particulars which are merely given for the purpose of information.

09-06-2017

| Patent document cited in search report | | | Publication date | Patent family member(s) | | | Publication date |
|---|---|---|---|---|---|---|---|
| US 2008204054 | A1 | | 28-08-2008 | CN | 101680922 | A | 24-03-2010 |
| | | | | RU | 2009135814 | A | 10-04-2011 |
| | | | | US | 2008204054 | A1 | 28-08-2008 |
| | | | | WO | 2008106550 | A2 | 04-09-2008 |
| US 2012191440 | A1 | | 26-07-2012 | CA | 2825780 | A1 | 02-08-2012 |
| | | | | US | 2012191440 | A1 | 26-07-2012 |
| | | | | US | 2015161298 | A1 | 11-06-2015 |
| | | | | WO | 2012103246 | A2 | 02-08-2012 |
| US 2014320148 | A1 | | 30-10-2014 | CN | 105143894 | A | 09-12-2015 |
| | | | | EP | 2992339 | A1 | 09-03-2016 |
| | | | | US | 2014320148 | A1 | 30-10-2014 |
| | | | | WO | 2014179102 | A1 | 06-11-2014 |

EPO FORM P0459

For more details about this annex : see Official Journal of the European Patent Office, No. 12/82